# EUROPEAN PATENT APPLICATION

(11) **EP 2 579 323 A1**
(43) Date of publication of application: **10.04.2013**
(21) Application number: 11786424.9
(22) Date of filing: 08.04.2011
(51) Int. Cl.: H01L 31/04

(54) **INTERMEDIATE LAYER FOR LAMINATE-TYPE PHOTOELECTRIC CONVERSION DEVICE, LAMINATE-TYPE PHOTOELECTRIC CONVERSION DEVICE, AND PROCESS FOR PRODUCTION OF LAMINATE-TYPE PHOTOELECTRIC CONVERSION DEVICE**

(30) Priority: 26.05.2010 JP 2010120174
(71) Applicant: Sharp Kabushiki Kaisha, Osaka-shi, Osaka 545-8522 (JP)
(72) Inventor: KISHIMOTO, Katsushi, Osaka 545-8522 (JP); MIZUTA, Masanori, Osaka 545-8522 (JP)
(74) Representative: Müller - Hoffmann & Partner
(86) International application number: PCT/JP2011/058900
(87) International publication number: WO 2011/148724

(57) **Abstract**

An intermediate layer (4) for a stacked type photoelectric conversion device including an n-type silicon-based stacked body (41) including an n-type crystalline silicon-based semiconductor layer (41a) and an n-type silicon-based composite layer (41 b), and a p-type silicon-based stacked body (42) including a p-type crystalline silicon-based semiconductor layer (42a) and a p-type silicon-based composite layer (42b), the n-type crystalline silicon-based semiconductor layer (41a) of the n-type silicon-based stacked body (41) being in contact with the p-type crystalline silicon-based semiconductor layer (42a) of the p-type silicon-based stacked body (42), a stacked type photoelectric conversion device including the same, and a method for manufacturing a stacked type photoelectric conversion device.

## Description

### TECHNICAL FIELD

The present invention relates to an intermediate layer for a stacked type photoelectric conversion device, a stacked type photoelectric conversion device, and a method for manufacturing a stacked type photoelectric conversion device.

### BACKGROUND ART

Photoelectric conversion devices capable of converting light energy into electrical energy have been attracting attention in recent years, and particularly, attention has been drawn to a stacked type photoelectric conversion device having a structure in which two or more photoelectric conversion units are stacked, for the purpose of enhancing the conversion efficiency of a photoelectric conversion device.

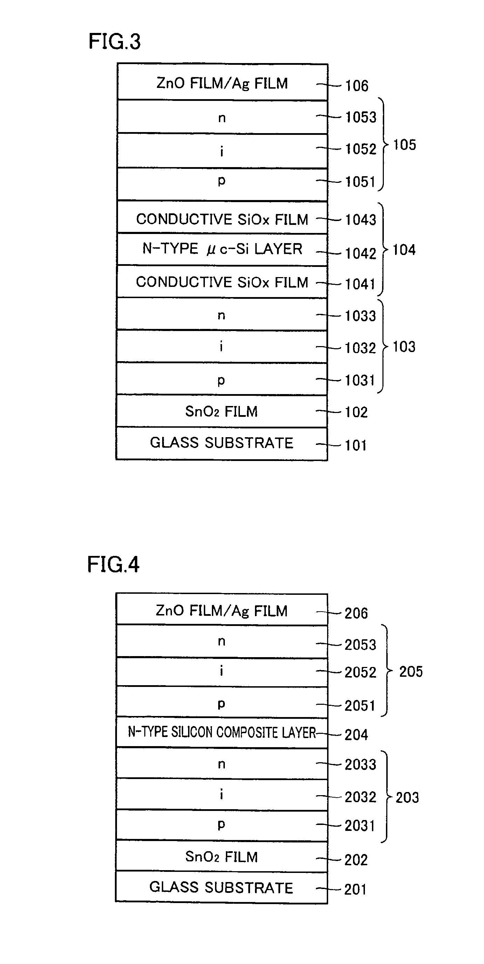

Fig. 3 shows a schematic cross-sectional view of the conventional stacked type photoelectric conversion device described in PTL 1 (Japanese Patent Laying-Open No. 2006-319068). Here, the stacked type photoelectric conversion device shown in Fig. 3 has a structure having, on a glass substrate 101, an SnO₂ film 102, a boron-doped p-type SiC layer 1031, a non-doped i-type amorphous Si layer 1032, a phosphorus-doped n-type µc-Si layer 1033, a conductive SiOₓ layer 1041 having n-type conductivity, an n-type µc-Si layer 1042, a conductive SiOₓ layer 1043 having n-type conductivity, a boron-doped p-type µc-Si layer 1051, a non-doped i-type crystalline Si layer 1052, a phosphorus-doped n-type µc-Si layer 1053, and a stacked body 106 of a ZnO film and an Ag film, in this order (paragraphs [0031] to [0035] in PTL 1).

In the stacked type photoelectric conversion device shown in Fig. 3, p-type SiC layer 1031, i-type amorphous Si layer 1032, and n-type µc-Si layer 1033 form an amorphous photoelectric conversion unit 103. Moreover, conductive SiOₓ layer 1041, n-type µc-Si layer 1042, and conductive SiOₓ layer 1043 form an intermediate layer 104. Furthermore, p-type µc-Si layer 1051, i-type crystalline Si layer 1052, and n-type µc-Si layer 1053 form a crystalline silicon photoelectric conversion unit 105.

Fig. 4 shows a schematic cross-sectional view of the conventional stacked type photoelectric conversion device described in PTL 2 (Japanese Patent Laying-Open No. 2005-45129). Here, the stacked type photoelectric conversion device shown in Fig. 4 has a structure having, on a glass substrate 201, an SnO₂ film 202, a p-type amorphous SiC layer 2031, an i-type amorphous Si layer 2032, an n-type µc-Si layer 2033, an n-type silicon composite layer 204, a p-type µc-Si layer 2051, an i-type crystalline Si layer 2052, an n-type µc-Si layer 2053, and a stacked body 206 of a ZnO film and an Ag film, in this order (paragraphs [0090] and [0095] in PTL2).

In the stacked type photoelectric conversion device shown in Fig. 4, p-type amorphous SiC layer 2031, i-type amorphous Si layer 2032, and n-type µc-Si layer 2033 form a front photoelectric conversion unit 203. Moreover, p-type µc-Si layer 2051, i-type crystalline Si layer 2052, and n-type µc-Si layer 2053 form a rear photoelectric conversion unit 205.

In each of the stacked type photoelectric conversion devices shown in Figs. 3 and 4, intermediate layer 104 or n-type silicon composite layer 204 is provided as an intermediate layer between the photoelectric conversion units. Thus, each of intermediate layer 104 and n-type silicon composite layer 204 functions as a reflecting layer to allow an increase in the amount of light absorption by a photoelectric conversion unit that is located closer to a light incident-side than the intermediate layer, leading to an increased current value that can be generated by the photoelectric conversion unit (paragraph [0006] of PTL 1 and paragraph [0010] of PTL 2).

### CITATION LIST

### PATENT LITERATURE

PTL 1: Japanese Patent Laying-Open No. 2006-319068
PTL 2: Japanese Patent Laying-Open No. 2005-45129

### SUMMARY OF INVENTION

### TECHNICAL PROBLEM

As described above, while characteristics of a stacked type photoelectric conversion device can be improved by providing an intermediate layer that functions as a reflecting layer between photoelectric conversion units, there is a demand for the development of a stacked type photoelectric conversion device having further improved characteristics, due to the recent increased expectations for photoelectric conversion devices.

In view of the above-described circumstances, an object of the present invention is to provide an intermediate layer for a stacked type photoelectric conversion device that allows manufacture of a stacked type photoelectric conversion device having excellent characteristics, a stacked type photoelectric conversion device including the same, and a method for manufacturing a stacked type photoelectric conversion device.

### SOLUTION TO PROBLEM

The present invention is directed to an intermediate layer for a stacked type photoelectric conversion device including an n-type silicon-based stacked body including an n-type crystalline silicon-based semiconductor layer and an n-type silicon-based composite layer, and a p-type silicon-based stacked body including a p-type crystalline silicon-based semiconductor layer and a p-type silicon-based composite layer, the n-type crystalline silicon-based semiconductor layer of the n-type silicon-based stacked body being in contact with the p-type crystalline silicon-based semiconductor layer of the p-type silicon-based stacked body.

Here, in the intermediate layer for a stacked type photoelectric conversion device according to the present invention, preferably, the n-type crystalline silicon-based semiconductor layer and the n-type silicon-based composite layer are alternately stacked on each other in the n-type silicon-based stacked body, and the p-type crystalline silicon-based semiconductor layer and the p-type silicon-based composite layer are alternately stacked on each other in the p-type silicon-based stacked body.

Moreover, in the intermediate layer for a stacked type photoelectric conversion device according to the present invention, preferably, the n-type silicon-based composite layer includes an n-type crystalline silicon-based semiconductor and an insulating silicon-based compound.

Furthermore, in the intermediate layer for a stacked type photoelectric conversion device according to the present invention, preferably, the n-type silicon-based stacked body has an n-type impurity concentration of not lower than 3.95 × 10¹⁸ atoms/cm³ and not higher than 2 × 10²² atoms/cm³.

Moreover, in the intermediate layer for a stacked type photoelectric conversion device according to the present invention, preferably, the p-type silicon-based composite layer includes a p-type crystalline silicon-based semiconductor and an insulating silicon-based compound.

Moreover, in the intermediate layer for a stacked type photoelectric conversion device according to the present invention, preferably, the p-type silicon-based stacked body has a p-type impurity concentration of not lower than 3.76 × 10¹⁹ atoms/cm³ and not higher than 2 × 10²¹ atoms/cm³.

Furthermore, the present invention is directed to a stacked type photoelectric conversion device including any of the above-described intermediate layers for a stacked type photoelectric conversion device, a first photoelectric conversion unit provided on one surface of the intermediate layer for a stacked type photoelectric conversion device, and a second photoelectric conversion unit provided on the other surface of the intermediate layer for a stacked type photoelectric conversion device, the first photoelectric conversion unit including an n-type silicon-based semiconductor layer facing the intermediate layer for a stacked type photoelectric conversion device, the second photoelectric conversion unit including a p-type silicon-based semiconductor layer facing the intermediate layer for a stacked type photoelectric conversion device, the n-type silicon-based composite layer of the intermediate layer for a stacked type photoelectric conversion device being in contact with the n-type silicon-based semiconductor layer of the first photoelectric conversion unit, and the p-type silicon-based composite layer of the intermediate layer for a stacked type photoelectric conversion device being in contact with the p-type silicon-based semiconductor layer of the second photoelectric conversion unit.

Here, in the stacked type photoelectric conversion device according to the present invention, preferably, the n-type silicon-based semiconductor layer of the first photoelectric conversion unit has an n-type impurity concentration of not lower than 1 × 10¹⁹ atoms/cm³ and not higher than 2 × 10²¹ atoms/cm³.

Moreover, in the stacked type photoelectric conversion device according to the present invention, preferably, the p-type silicon-based semiconductor layer of the second photoelectric conversion unit has a p-type impurity concentration of not lower than 1 × 10¹⁸ atoms/cm³ and not higher than 2 × 10²² atoms/cm³.

Furthermore, the present invention is directed to a method for manufacturing a stacked type photoelectric conversion device including the steps of forming a first photoelectric conversion unit by stacking a p-type silicon-based semiconductor layer, an i-type silicon-based semiconductor layer, and an n-type silicon-based semiconductor layer in this order on a transparent substrate, forming any of the above-described intermediate layers for a stacked type photoelectric conversion device on the first photoelectric conversion unit, and forming a second photoelectric conversion unit by stacking a p-type silicon-based semiconductor layer, an i-type silicon-based semiconductor layer, and an n-type silicon-based semiconductor layer in this order on the intermediate layer for a stacked type photoelectric conversion device, the step of forming the intermediate layer for a stacked type photoelectric conversion device including the step of stacking the n-type silicon-based composite layer of the intermediate layer for a stacked type photoelectric conversion device to be in contact with the n-type silicon-based semiconductor layer of the first photoelectric conversion unit, and the step of forming the second photoelectric conversion unit including the step of stacking the p-type silicon-based semiconductor layer of the second photoelectric conversion unit to be in contact with the p-type silicon-based composite layer of the intermediate layer for a stacked type photoelectric conversion device.

### ADVANTAGEOUS EFFECTS OF INVENTION

According to the present invention, an intermediate layer for a stacked type photoelectric conversion device that allows manufacture of a stacked type photoelectric conversion device having excellent characteristics, a stacked type photoelectric conversion device including the same, and a method for manufacturing a stacked type photoelectric conversion device can be provided.

### BRIEF DESCRIPTION OF DRAWINGS

Fig. 1 is a schematic cross-sectional view of a stacked type photoelectric conversion device according to a first embodiment.
Fig. 2 is a schematic cross-sectional view of a stacked type photoelectric conversion device according to a second embodiment.
Fig. 3 is a schematic cross-sectional view of the conventional stacked type photoelectric conversion device described in PTL 1.
Fig. 4 is a schematic cross-sectional view of the conventional stacked type photoelectric conversion device described in PTL 2.

### DESCRIPTION OF EMBODIMENTS

Embodiments of the present invention will be described hereinafter.

In the drawings of the present invention, the same or corresponding elements are denoted by the same reference characters.

### <First Embodiment>

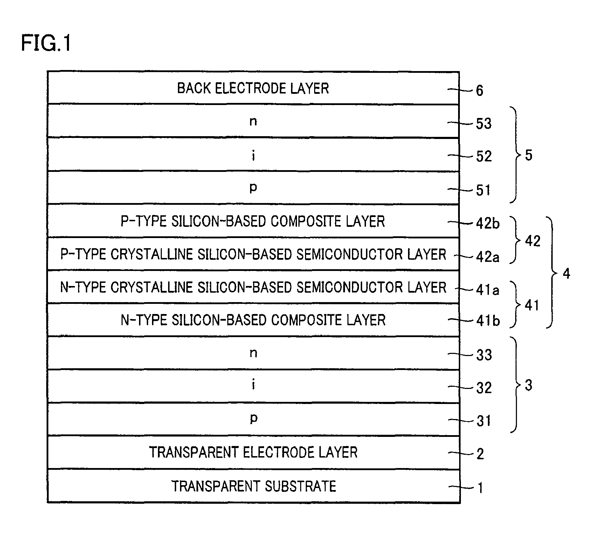

Fig. 1 shows a schematic cross-sectional view showing a stacked type photoelectric conversion device according to the first embodiment, which is one example of a stacked type photoelectric conversion device according to the present invention. The stacked type photoelectric conversion device according to the first embodiment has a transparent substrate 1, and has a transparent electrode layer 2, a first p-type silicon-based semiconductor layer 31, a first i-type silicon-based semiconductor layer 32, a first n-type silicon-based semiconductor layer 33, an n-type silicon-based composite layer 41b, an n-type crystalline silicon-based semiconductor layer 41a, a p-type crystalline silicon-based semiconductor layer 42a, a p-type silicon-based composite layer 42b, a second p-type silicon-based semiconductor layer 51, a second i-type silicon-based semiconductor layer 52, a second n-type silicon-based semiconductor layer 53, and a back electrode layer 6, which are stacked on transparent substrate 1.

Here, first p-type silicon-based semiconductor layer 31, first i-type silicon-based semiconductor layer 32, and first n-type silicon-based semiconductor layer 33 form a first photoelectric conversion unit 3. N-type silicon-based composite layer 41 b and n-type crystalline silicon-based semiconductor layer 41a form an n-type silicon-based stacked body 41. P-type crystalline silicon-based semiconductor layer 42a and p-type silicon-based composite layer 42b form a p-type silicon-based stacked body 42. N-type silicon-based stacked body 41 and p-type silicon-based stacked body 42 form an intermediate layer 4 for a stacked type photoelectric conversion device. Second p-type silicon-based semiconductor layer 51, second i-type silicon-based semiconductor layer 52, and second n-type silicon-based semiconductor layer 53 form a second photoelectric conversion unit 5.

As transparent substrate 1, a translucent substrate through which light can pass may be used, for example, a glass substrate, a resin substrate containing a transparent resin such as a polyimide resin, or a substrate obtained by stacking a plurality of these substrates.

As transparent electrode layer 2, a conductive film through which light can pass may be used, for example, a single layer of a tin oxide layer, an ITO (Indium Tin Oxide) film, a zinc oxide film, or a film obtained by adding a trace amount of an impurity to any of these films, or a plurality of layers obtained by stacking a plurality of these layers. Where transparent electrode layer 2 is constituted of a plurality of layers, all of the layers may be formed of the same material, or at least one layer may be formed of a material different from that of the others.

Transparent electrode layer 2 preferably has a concavo-convex shape, for example, on a surface thereof. The concavo-convex shape formed on the surface of transparent electrode layer 2 allows the optical path length to be extended by scattering and/or refracting incident light entering from a transparent substrate 1-side, which enhances a light confinement effect within first photoelectric conversion unit 3, and therefore an increased short-circuit current density tends to be achieved. As a method for forming a concavo-convex shape on the surface of transparent electrode layer 2, a mechanical method such as etching or sand blasting, or a method utilizing crystal growth of transparent electrode layer 2 may be used, for example.

As first p-type silicon-based semiconductor layer 31, a single layer of a p-type silicon-based semiconductor layer such as a p-type amorphous silicon layer, a p-type microcrystalline silicon layer, a p-type amorphous silicon carbide layer, or a p-type amorphous silicon nitride layer, or a plurality of layers obtained by stacking a plurality of these layers may be used, for example. Where first p-type silicon-based semiconductor layer 31 is constituted of a plurality of layers, all of the layers may be formed of the same semiconductor material, or at least one layer may be formed of a semiconductor material different from that of the others. Boron, for example, may be used as a p-type impurity to be doped into first p-type silicon-based semiconductor layer 31.

As first i-type silicon-based semiconductor layer 32, a single layer of an amorphous silicon layer or a plurality of layers thereof may be used, for example. First i-type silicon-based semiconductor layer 32 is a non-doped layer doped with neither a p-type impurity nor n-type impurity.

As first n-type silicon-based semiconductor layer 33, a single layer of an n-type layer such as an n-type amorphous silicon layer or an n-type microcrystalline silicon layer, or a plurality of layers obtained by stacking a plurality of these layers may be used, for example. Where first n-type silicon-based semiconductor layer 33 is constituted of a plurality of layers, all of the layers may be formed of the same semiconductor material, or at least one layer may be formed of a semiconductor material different from that of the others. Phosphorus, for example, may be used as an n-type impurity to be doped into first n-type silicon-based semiconductor layer 33.

First n-type silicon-based semiconductor layer 33 preferably has an n-type impurity concentration of not lower than 1 × 10¹⁹ atoms/cm³ and not higher than 2 × 10²¹ atoms/cm³. When first n-type silicon-based semiconductor layer 33 has an n-type impurity concentration of not lower than 1 × 10¹⁹ atoms/cm³ and not higher than 2 × 10²¹ atoms/cm³, characteristics of the stacked type photoelectric conversion device tends to be further improved.

The n-type impurity concentration in first n-type silicon-based semiconductor layer 33 corresponds to a value obtained by dividing a total number of atoms of the n-type impurity contained in first n-type silicon-based semiconductor layer 33 by a volume of first n-type silicon-based semiconductor layer 33. Here, where first n-type silicon-based semiconductor layer 33 contains two or more types of n-type impurities, the total number of atoms of the n-type impurities corresponds to a total number of atoms of the two or more types of n-type impurities. While the n-type impurity concentration in first n-type silicon-based semiconductor layer 33 may be set depending on, for example, the flow rate of a dopant gas introduced at the time of vapor deposition of first n-type silicon-based semiconductor layer 33, it may be measured by SIMS (Secondary Ion Mass Spectrometry), for example, after the formation of first n-type silicon-based semiconductor layer 33.

It is noted that the semiconductor material used for first p-type silicon-based semiconductor layer 31 and first n-type silicon-based semiconductor layer 33 may be the same or different from the semiconductor material of first i-type silicon-based semiconductor layer 32. For example, a p-type amorphous silicon layer may be used for first p-type silicon-based semiconductor layer 31, an amorphous silicon layer may be used for first i-type silicon-based semiconductor layer 32, and an n-type microcrystalline silicon layer may be used for first n-type silicon-based semiconductor layer 33. Alternatively, a p-type amorphous silicon carbide layer may be used for first p-type silicon-based semiconductor layer 31, an amorphous silicon layer may be used for first i-type silicon-based semiconductor layer 32, and an n-type microcrystalline silicon layer may be used for first n-type silicon-based semiconductor layer 33.

In the present specification, the term "amorphous silicon" is a concept that includes "hydrogenated amorphous silicon", and the term "microcrystalline silicon" is a concept that includes "hydrogenated microcrystalline silicon".

N-type silicon-based composite layer 41b is stacked on first n-type silicon-based semiconductor layer 33 to be in contact therewith. N-type silicon-based composite layer 41b is a layer of n-type conductivity including a crystalline silicon-based semiconductor and an insulating silicon-based compound. N-type silicon-based composite layer 41b preferably has a structure in which a plurality of crystal grains of the crystalline silicon-based semiconductor connected in a thickness direction of n-type silicon-based composite layer 41 b are surrounded with the insulating silicon-based compound. When n-type silicon-based composite layer 41b has this structure, it tends to have conductivity while having both light transmitting property and light reflecting property. In this case, therefore, a portion of light that has reached n-type silicon-based composite layer 41b can be reflected toward first photoelectric conversion unit 3, which allows an increase in the amount of light absorption by first photoelectric conversion unit 3 that is located closer to a light incident-side than n-type silicon-based composite layer 41 b. Hence, the amount of current generated by first photoelectric conversion unit 3 is increased, so that characteristics of the stacked type photoelectric conversion device tends to be improved. As the insulating silicon-based compound of n-type silicon-based composite layer 41 b, a silicon-based oxide such as silicon oxide, or a silicon-based nitride such as silicon nitride may be used, for example. Phosphorus, for example, may be used as an n-type impurity to be doped into n-type silicon-based composite layer 41b. In the present specification, the term "crystalline" is a concept that includes so-called "microcrystalline". In the present specification, the so-called "microcrystalline" includes a crystal phase as well as partially amorphous.

N-type silicon-based composite layer 41 b preferably has an n-type impurity concentration of not lower than 3.95 × 10¹⁸ atoms/cm³ and not higher than 2 × 10²² atoms/cm³, and more preferably of not lower than 5 × 10¹⁹ atoms/cm³ and not higher than 2 × 10²² atoms/cm³. When n-type silicon-based composite layer 41 b has an n-type impurity concentration of not lower than 3.95 × 10¹⁸ atoms/cm³ and not higher than 2 × 10²² atoms/cm³, and in particular, not lower than 5 × 10¹⁹ atoms/cm³ and not higher than 2 × 10²² atoms/cm³, characteristics of the stacked type photoelectric conversion device tends to be improved.

The n-type impurity concentration in n-type silicon-based composite layer 41 b corresponds to a value obtained by dividing a total number of atoms of the n-type impurity contained in n-type silicon-based composite layer 41b by a volume of n-type silicon-based composite layer 41b. Here, where n-type silicon-based composite layer 41b contains two or more types of n-type impurities, the total number of atoms of the n-type impurities corresponds to a total number of atoms of the two or more types of n-type impurities. While the n-type impurity concentration in n-type silicon-based composite layer 41b may be set depending on, for example, the flow rate of a dopant gas introduced at the time of vapor deposition of n-type silicon-based composite layer 41b, it may be measured by SIMS, for example, after the formation of n-type silicon-based composite layer 41b.

N-type crystalline silicon-based semiconductor layer 41a is stacked on n-type silicon-based composite layer 41b to be in contact therewith. Phosphorus, for example, may be used as an n-type impurity to be doped into n-type crystalline silicon-based semiconductor layer 41 a.

N-type crystalline silicon-based semiconductor layer 4 1 a preferably has an n-type impurity concentration of not lower than 3.95 × 10¹⁸ atoms/cm³ and not higher than 2 × 10²² atoms/cm³, and more preferably not lower than 5 × 10¹⁹ atoms/cm³ and not higher than 2 × 10²² atoms/cm³. When n-type crystalline silicon-based semiconductor layer 41 a has an n-type impurity concentration of not lower than 3.95 × 10¹⁸ atoms/cm³ and not higher than 2 × 10²² atoms/cm³, and in particular, not lower than 5 × 10¹⁹ atoms/cm³ and not higher than 2 × 10²² atoms/cm³, characteristics of the stacked type photoelectric conversion device tends to be improved.

The n-type impurity concentration in n-type crystalline silicon-based semiconductor layer 4 1 a corresponds to a value obtained by dividing a total number of atoms of the n-type impurity contained in n-type crystalline silicon-based semiconductor layer 41 a by a volume of n-type crystalline silicon-based semiconductor layer 41a. Here, where n-type crystalline silicon-based semiconductor layer 41 a contains two or more types of n-type impurities, the total number of atoms of the n-type impurities corresponds to a total number of atoms of the two or more types of n-type impurities. While the n-type impurity concentration in n-type crystalline silicon-based semiconductor layer 4 1 a may be set depending on, for example, the flow rate of a dopant gas introduced at the time of vapor deposition of n-type crystalline silicon-based semiconductor layer 41 a, it may be measured by SIMS, for example, after the formation of n-type crystalline silicon-based semiconductor layer 41a.

N-type silicon-based stacked body 41 formed of a stacked body of n-type silicon-based composite layer 41b and n-type crystalline silicon-based semiconductor layer 41a preferably has an n-type impurity concentration of not lower than 3.95 × 10¹⁸ atoms/cm³ and not higher than 2 × 10²² atoms/cm³, and more preferably not lower than 5 × 10¹⁹ atoms/cm³ and not higher than 2 × 10²² atoms/cm³. When n-type silicon-based stacked body 41 has an n-type impurity concentration of not lower than 3.95 × 10¹⁸ atoms/cm³ and not higher than 2 × 10²² atoms/cm³, and in particular, not lower than 5 × 10¹⁹ atoms/cm³ and not higher than 2 × 10²² atoms/cm³, characteristics of the stacked type photoelectric conversion device tends to be further improved.

The n-type impurity concentration in n-type silicon-based stacked body 41 corresponds to a value obtained by dividing a total number of atoms of the n-type impurity contained in n-type silicon-based stacked body 41 by a volume of n-type silicon-based stacked body 41. Here, where n-type silicon-based stacked body 41 contains two or more types of n-type impurities, the total number of atoms of the n-type impurities corresponds to a total number of atoms of the two or more types of n-type impurities. While the n-type impurity concentration in n-type silicon-based stacked body 41 may be set depending on, for example, the flow rate of a dopant gas introduced at the time of vapor deposition of each of n-type crystalline silicon-based semiconductor layer 4 1 a and n-type silicon-based composite layer 41b that form n-type silicon-based stacked body 41, it may be measured by SIMS, for example, after the formation of n-type silicon-based stacked body 41.

P-type crystalline silicon-based semiconductor layer 42a is stacked on n-type crystalline silicon-based semiconductor layer 41a to be in contact therewith. Boron, for example, may be used as a p-type impurity to be doped into p-type crystalline silicon-based semiconductor layer 42a.

P-type crystalline silicon-based semiconductor layer 42a preferably has a p-type impurity concentration of not lower than 3.76 × 10¹⁹ atoms/cm³ and not higher than 2 × 10²¹ atoms/cm³, and more preferably not lower than 5 × 10¹⁹ atoms/cm³ and not higher than 2 × 10²¹ atoms/cm³. When p-type crystalline silicon-based semiconductor layer 42a has a p-type impurity concentration of not lower than 3.76 × 10¹⁹ atoms/cm³ and not higher than 2 × 10²¹ atoms/cm³, and in particular, not lower than 5 × 10¹⁹ atoms/cm³ and not higher than 2 × 10²¹ atoms/cm³, characteristics of the stacked type photoelectric conversion device tends to be further improved.

The p-type impurity concentration in p-type crystalline silicon-based semiconductor layer 42a corresponds to a value obtained by dividing a total number of atoms of the p-type impurity contained in p-type crystalline silicon-based semiconductor layer 42a by a volume of p-type crystalline silicon-based semiconductor layer 42a. Here, where p-type crystalline silicon-based semiconductor layer 42a contains two or more types of p-type impurities, the total number of atoms of the p-type impurities corresponds to a total number of atoms of the two or more types of p-type impurities. While the p-type impurity concentration in p-type crystalline silicon-based semiconductor layer 42a may be set depending on, for example, the flow rate of a dopant gas introduced at the time of vapor deposition of p-type crystalline silicon-based semiconductor layer 42a, it may be measured by SIMS, for example, after the formation of p-type crystalline silicon-based semiconductor layer 42a.

P-type silicon-based composite layer 42b is stacked on p-type crystalline silicon-based semiconductor layer 42a to be in contact therewith. P-type silicon-based composite layer 42b is a layer of p-type conductivity including a crystalline silicon-based semiconductor layer and an insulating silicon-based compound. P-type silicon-based composite layer 42b preferably has a structure in which a plurality of crystal grains of the crystalline silicon-based semiconductor connected in a thickness direction of p-type silicon-based composite layer 42b are surrounded with the insulating silicon-based compound. When p-type silicon-based composite layer 42b has this structure, it tends to have conductivity while having both light transmitting property and light reflecting property. In this case, therefore, a portion of light that has reached p-type silicon-based composite layer 42b can be reflected toward second photoelectric conversion unit 5, which allows an increase in the amount of light absorption by second photoelectric conversion unit 5 that is located closer to a light incident-side than p-type silicon-based composite layer 42b. Hence, the amount of current generated by second photoelectric conversion unit 5 is increased, so that characteristics of the stacked type photoelectric conversion device tends to be improved. As the insulating silicon-based compound of p-type silicon-based composite layer 42b, a silicon-based oxide such as silicon oxide, or a silicon-based nitride such as silicon nitride may be used, for example. Boron, for example, may be used as a p-type impurity to be doped into p-type silicon-based composite layer 42b.

P-type silicon-based composite layer 42b preferably has a p-type impurity concentration of not lower than 3.76 × 10¹⁹ atoms/cm³ and not higher than 2 × 10²¹ atoms/cm³, and more preferably not lower than 5 × 10¹⁹ atoms/cm³ and not higher than 2 × 10²¹ atoms/cm³. When p-type silicon-based composite layer 42b has a p-type impurity concentration of not lower than 3.76 × 10¹⁹ atoms/cm³ and not higher than 2 × 10²¹ atoms/cm³, and in particular, not lower than 5 × 10¹⁹ atoms/cm³ and not higher than 2 × 10²¹ atoms/cm³, characteristics of the stacked type photoelectric conversion device tends to be further improved.

The p-type impurity concentration in p-type silicon-based composite layer 42b corresponds to a value obtained by dividing a total number of atoms of the p-type impurity contained in p-type silicon-based composite layer 42b by a volume of p-type silicon-based composite layer 42b. Here, where p-type silicon-based composite layer 42b contains two or more types of p-type impurities, the total number of atoms of the p-type impurities corresponds to a total number of atoms of the two or more types of p-type impurities. While the p-type impurity concentration in p-type silicon-based composite layer 42b may be set depending on, for example, the flow rate of a dopant gas introduced at the time of vapor deposition of p-type silicon-based composite layer 42b, it may be measured by SIMS, for example, after the formation of p-type silicon-based composite layer 42b.

P-type silicon-based stacked body 42 formed of a stacked body of p-type crystalline silicon-based semiconductor layer 42a and p-type silicon-based semiconductor layer 42b preferably has a p-type impurity concentration of not lower than 3.76 × 10¹⁹ atoms/cm³ and not higher than 2 × 10²¹ atoms/cm³, and more preferably not lower than 5 × 10¹⁹ atoms/cm³ and not higher than 2 × 10²¹ atoms/cm³. When p-type silicon-based stacked body 42 has a p-type impurity concentration of not lower than 3.76 × 10¹⁹ atoms/cm³ and not higher than 2 × 10²¹ atoms/cm³, and in particular, not lower than 5 × 10¹⁹ atoms/cm³ and not higher than 2 × 10²¹ atoms/cm³, characteristics of the stacked type photoelectric conversion device tends to be further improved.

The p-type impurity concentration in p-type silicon-based stacked body 42 corresponds to a value obtained by dividing a total number of atoms of the p-type impurity contained in p-type silicon-based stacked body 42 by a volume of p-type silicon-based stacked body 42. Here, where p-type silicon-based stacked body 42 contains two or more types of p-type impurities, the total number of atoms of the p-type impurities corresponds to a total number of atoms of the two or more types of p-type impurities. While the p-type impurity concentration in p-type silicon-based stacked body 42 may be set depending on, for example, the flow rate of a dopant gas introduced at the time of vapor deposition of each of p-type crystalline silicon-based semiconductor layer 42a and p-type silicon-based composite layer 42b that form p-type silicon-based stacked body 42, it may be measured by SIMS, for example, after the formation of p-type silicon-based stacked body 42.

Second p-type silicon-based semiconductor layer 51 is stacked on p-type silicon-based composite layer 42b to be in contact therewith. As second p-type silicon-based semiconductor layer 51, a single layer of a p-type layer such as a p-type microcrystalline silicon layer, a p-type microcrystalline silicon carbide layer, or a p-type microcrystalline silicon nitride layer, or a plurality of layers obtained by stacking a plurality of these layers may be used, for example. Where second p-type silicon-based semiconductor layer 51 is constituted of a plurality of layers, all of the layers may be formed of the same semiconductor material, or at least one layer may be formed of a semiconductor material different from that of the others. Boron, for example, may be used as a p-type impurity to be doped into second p-type silicon-based semiconductor layer 51.

Second p-type silicon-based semiconductor layer 51 preferably has a p-type impurity concentration of not lower than 1 × 10¹⁸ atoms/cm³ and not higher than 2 × 10²² atoms/cm³. When second p-type silicon-based semiconductor layer 51 has a p-type impurity concentration of not lower than 1 × 10¹⁸ atoms/cm³ and not higher than 2 × 10²² atoms/cm³, characteristics of the stacked type photoelectric conversion device tends to be further improved.

As second i-type silicon-based semiconductor layer 52, a single layer of a crystalline silicon layer or a plurality of layers thereof may be used. Second i-type silicon-based semiconductor layer 52 is a non-doped layer doped with neither a p-type impurity nor n-type impurity.

As second n-type silicon-based semiconductor layer 53, a single layer of an n-type layer such as an n-type amorphous silicon layer or an n-type microcrystalline silicon layer, or a plurality of layers obtained by stacking a plurality of these layers may be used, for example. Where second n-type silicon-based semiconductor layer 53 is constituted of a plurality of layers, all of the layers may be formed of the same semiconductor material, or at least one layer may be formed of a semiconductor material different from that of the others. Phosphorus, for example, may be used as an n-type impurity to be doped into second n-type silicon-based semiconductor layer 53.

A conductor layer may be used as back electrode layer 6, such as a stacked body of a transparent conductive film and a reflecting electrode, for example.

As the transparent conductive film, a conductive film through which light can pass may be used, for example, a single layer of a tin oxide layer, an ITO film, a zinc oxide film, or a film obtained by adding a trace amount of an impurity to any of these films, or a plurality of layers obtained by stacking a plurality of these layers. Where the transparent conductive film is constituted of a plurality of layers, all of the layers may be formed of the same material, or at least one layer may be formed of a material different from that of the others. As the reflecting electrode, a conductive layer such as an Ag (silver) layer, an Al (aluminum) layer, or a stacked body thereof may be used, for example.

In addition to achieving enhanced light confinement and an enhanced light reflectance for incident light, the transparent conductive film can suppress diffusion of atoms constituting the reflecting electrode into second photoelectric conversion unit 5 by virtue of its presence. Thus, back electrode layer 6 preferably includes a transparent conductive film.

The reflecting electrode contributes to improved conversion efficiency because it can reflect light that has not been absorbed by first photoelectric conversion unit 3 and second photoelectric conversion unit 5 and return it thereto.

Since intermediate layer 4 for a stacked type photoelectric conversion device is used in the stacked type photoelectric conversion device according to the first embodiment, first photoelectric conversion unit 3 and intermediate layer 4 for a stacked type photoelectric conversion device can be joined by a junction between the n-type silicon-based semiconductors, and intermediate layer 4 for a stacked type photoelectric conversion device and second photoelectric conversion unit 5 can be joined by a junction between the p-type silicon-based semiconductors. Thus, in the stacked type photoelectric conversion device according to the first embodiment, contact between intermediate layer 4 for a stacked type photoelectric conversion device and each of photoelectric conversion units 3, 5 easily has ohmic characteristics, and the contact resistance also tends to be reduced, as compared to each of the conventional stacked type photoelectric conversion devices described in PTL 1 and PTL 2 in which an intermediate layer and a photoelectric conversion unit are joined by a junction between an n-type silicon-based semiconductor and a p-type silicon-based semiconductor.

It is noted that in the stacked type photoelectric conversion device according to the first embodiment, a junction between the n-type silicon-based semiconductor and the p-type silicon-based semiconductor is formed inside intermediate layer 4 for a stacked type photoelectric conversion device. Since this junction is made between the crystalline silicon-based semiconductors, it easily has ohmic characteristics, and the contact resistance also tends to be reduced, as compared to each of the conventional stacked type photoelectric conversion devices described in PTL 1 and PTL 2 in which the junction between an n-type silicon-based semiconductor and a p-type silicon-based semiconductor inside the stacked type photoelectric conversion device is not the one between crystalline silicon-based semiconductors.

Furthermore, a design inside intermediate layer 4 for a stacked type photoelectric conversion device of the stacked type photoelectric conversion device according to the first embodiment is made to reduce the contact resistance between n-type crystalline silicon-based semiconductor layer 41 a and p-type crystalline silicon-based semiconductor layer 42a, while characteristics such as the reflectances of n-type silicon-based composite layer 41b and p-type silicon-based composite layer 42b can be designed independently of that design. Thus, characteristics such as the reflectances of n-type silicon-based composite layer 41b and p-type silicon-based composite layer 42b can be adjusted to allow a greater amount of light to enter each of first photoelectric conversion unit 3 and second photoelectric conversion unit 5, which allows an increase in the amount of current generated by each of first photoelectric conversion unit 3 and second photoelectric conversion unit 5.

Furthermore, in the stacked type photoelectric conversion device according to the first embodiment, the n-type impurity concentration in n-type silicon-based composite layer 4 1 b of intermediate layer 4 for a stacked type photoelectric conversion device is preferably not lower than that in first n-type silicon-based semiconductor layer 33 of first photoelectric conversion unit 3. In this case, the contact resistance between n-type silicon-based composite layer 41 b and first n-type silicon-based semiconductor layer 33 tends to be further reduced, and thus characteristics of the stacked type photoelectric conversion device can further be improved.

Furthermore, in the stacked type photoelectric conversion device according to the first embodiment, the p-type impurity concentration in p-type silicon-based composite layer 42b of intermediate layer 4 for a stacked type photoelectric conversion device is preferably not lower than that in second p-type silicon-based semiconductor layer 51 of second photoelectric conversion unit 5. In this case, the contact resistance between p-type silicon-based composite layer 42b and second p-type silicon-based semiconductor layer 51 tends to be further reduced, and thus characteristics of the stacked type photoelectric conversion device can further be improved.

The stacked type photoelectric conversion device according to the first embodiment may be manufactured as follows, by way of example. Initially, transparent electrode layer 2 is formed on transparent substrate 1. Transparent electrode layer 2 may be formed by a sputtering method, a thermal CVD method, an electron beam evaporation method, a sol-gel process, a spraying method, or an electrodeposition method, for example.

Next, first photoelectric conversion unit 3 is formed by stacking a first p-type silicon-based semiconductor layer 31, a first i-type silicon-based semiconductor layer 32, and a first n-type silicon-based semiconductor layer 33 in this order on transparent electrode layer 2. Each of first p-type silicon-based semiconductor layer 31, first i-type silicon-based semiconductor layer 32, and first n-type silicon-based semiconductor layer 33 may be formed by a plasma CVD method, for example. Transparent electrode layer 2 may be formed on transparent substrate 1 in advance, in which case first photoelectric conversion unit 3 is formed by stacking first p-type silicon-based semiconductor layer 31, first i-type silicon-based semiconductor layer 32, and first n-type silicon-based semiconductor layer 33 in this order on transparent electrode layer 2 provided on transparent substrate 1 in advance.

Next, n-type silicon-based stacked body 41 is formed by stacking n-type silicon-based composite layer 41b and n-type crystalline silicon-based semiconductor layer 41a in this order on first n-type silicon-based semiconductor layer 33. Each of n-type silicon-based composite layer 41 b and n-type crystalline silicon-based semiconductor layer 41a may be formed by a plasma CVD method, for example. Here, n-type silicon-based composite layer 41b is stacked on first n-type silicon-based semiconductor layer 33 of first photoelectric conversion unit 3 to be in contact therewith.

Next, p-type silicon-based stacked body 42 is formed by stacking a p-type crystalline silicon-based semiconductor layer 42a and p-type silicon-based composite layer 42b in this order on n-type silicon-based stacked body 41. Thus, intermediate layer 4 for a stacked type photoelectric conversion device formed of a stacked body of n-type silicon-based stacked body 41 and p-type silicon-based stacked body 42 is formed.

Next, second photoelectric conversion unit 5 is formed by stacking second p-type silicon-based semiconductor layer 51, second i-type silicon-based semiconductor layer 52, and second n-type silicon-based semiconductor layer 53 in this order on p-type silicon-based composite layer 42b of p-type silicon-based stacked body 42. Each of second p-type silicon-based semiconductor layer 51, second i-type silicon-based semiconductor layer 52, and second n-type silicon-based semiconductor layer 53 may be formed by a plasma CVD method, for example. Here, second p-type silicon-based semiconductor layer 51 of second photoelectric conversion unit 5 is stacked on p-type silicon-based composite layer 42b of intermediate layer 4 for a stacked type photoelectric conversion device to be in contact therewith.

Next, back electrode layer 6 is formed by stacking a transparent conductive film and a reflecting electrode in this order on second n-type silicon-based semiconductor layer 53. Here, the transparent conductive film may be formed by a sputtering method, a CVD method, an electron beam evaporation method, a sol-gel process, a spraying method, or an electrodeposition method, for example. The reflecting electrode may be formed by a CVD method, a sputtering method, a vacuum deposition method, an electron beam evaporation method, a spraying method, a screen printing method, or an electrodeposition method, for example.

As a result, the stacked type photoelectric conversion device according to the first embodiment can be manufactured. In the stacked type photoelectric conversion device according to the first embodiment, first photoelectric conversion unit 3 and intermediate layer 4 for a stacked type photoelectric conversion device are joined by the junction between the semiconductors of the same conductivity type, and second photoelectric conversion unit 5 and intermediate layer 4 for a stacked type photoelectric conversion device are joined by the junction between the semiconductors of the same conductivity type, while the semiconductors of different conductivity types are joined by the junction between the crystalline silicon-based semiconductors inside intermediate layer 4 for a stacked type photoelectric conversion device. This reduces electric resistance inside the stacked type photoelectric conversion device, as compared to the conventional stacked type photoelectric conversion devices described in PTL 1 and PTL 2.

Furthermore, in the stacked type photoelectric conversion device according to the first embodiment, characteristics such as the reflectances of n-type silicon-based composite layer 41b and p-type silicon-based composite layer 42b of intermediate layer 4 for a stacked type photoelectric conversion device can be adjusted to allow a greater amount of light to enter each of first photoelectric conversion unit 3 and second photoelectric conversion unit 5, while the electric resistance inside the stacked type photoelectric conversion device as described above is kept low.

Therefore, in the stacked type photoelectric conversion device according to the first embodiment, more current can be generated by each of first photoelectric conversion unit 3 and second photoelectric conversion unit 5, and the generated current can be extracted outside through the stacked type photoelectric conversion device having a low electric resistance. Therefore, a stacked type photoelectric conversion device with excellent characteristics can be manufactured.

### <Second Embodiment>

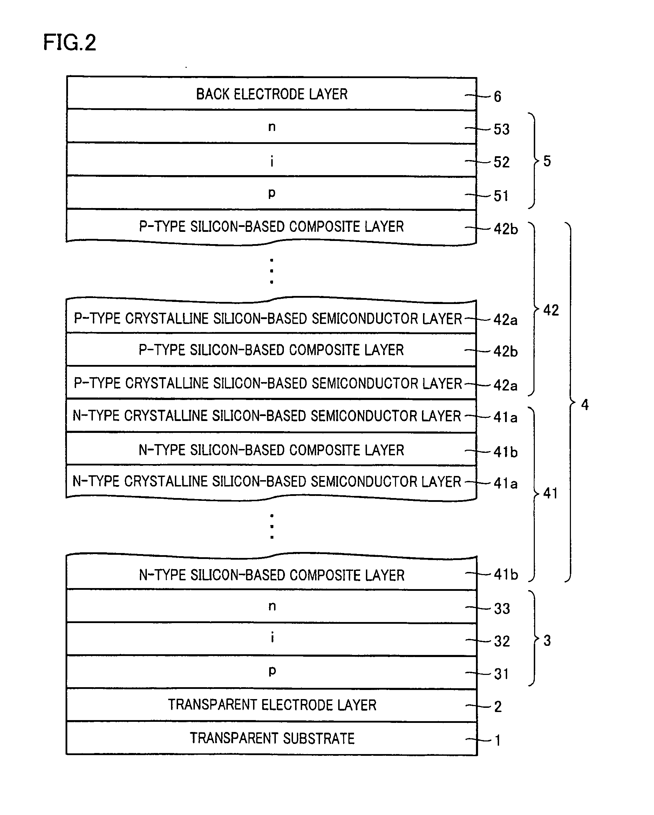

Fig. 2 shows a schematic cross-sectional view showing a stacked type photoelectric conversion device according to the second embodiment, which is another example of a stacked type photoelectric conversion device according to the present invention. The stacked type photoelectric conversion device according to the second embodiment has a feature in that n-type silicon-based stacked body 41 of intermediate layer 4 for a stacked type photoelectric conversion device includes a plurality of n-type crystalline silicon-based semiconductor layers 41a and a plurality of n-type silicon-based composite layers 41 b, with n-type crystalline silicon-based semiconductor layer 4 1 a and n-type silicon-based composite layer 4 1 b being alternately stacked on each other, and p-type silicon-based stacked body 42 includes a plurality of p-type crystalline silicon-based semiconductor layers 42a and a plurality of p-type silicon-based composite layers 42b, with p-type crystalline silicon-based semiconductor layer 42a and p-type silicon-based composite layer 42b being alternately stacked on each other.

The stacked type photoelectric conversion device according to the second embodiment has intermediate layer 4 for a stacked type photoelectric conversion device having the above-described structure. The light reflectance of intermediate layer 4 for a stacked type photoelectric conversion device for light having a specific wavelength can be adjusted by including the plurality of p-type crystalline silicon-based semiconductor layers 42a and the plurality of p-type silicon-based composite layers 42b. Specifically, in intermediate layer 4 for a stacked type photoelectric conversion device, power generation characteristics can be improved in both first photoelectric conversion unit 3 that tends to absorb light with shorter wavelengths and second photoelectric conversion unit 5 that tends to absorb light with longer wavelengths. As a result, a stacked type photoelectric conversion device even superior in characteristics to the stacked type photoelectric conversion device according to the first embodiment can be manufactured.

The description of the second embodiment other than the foregoing is the same as that of the first embodiment and thus will not repeated herein.

### Examples

### <Example 1>

Initially, an SnO₂ film having a thickness of 800 nm was formed on a surface of a glass substrate having a width of 1100 mm, a length of 1400 mm, and a thickness of 4 mm, using a thermal CVD method.

Next, a first photoelectric conversion unit is formed by stacking a p-type amorphous silicon carbide layer, an i-type amorphous silicon layer, and an n-type microcrystalline silicon layer in this order on the SnO₂ film by a plasma CVD method.

The p-type amorphous silicon carbide layer was formed to have a thickness of 10 nm, under the following conditions: a reactant gas having a flow rate ratio of SiH₄:H₂:CH₄:B₂H₆=1:12:2:0.002; a reactant gas pressure of 150 Pa; a substrate temperature of 185°C; and a high-frequency discharge power density of 0.03 W/cm².

The i-type amorphous silicon layer was formed to have a thickness of 300 nm, under the following conditions: a reactant gas having a flow rate ratio of SiH₄:H₂=1:0; a reactant gas pressure of 40 Pa; a substrate temperature of 185°C; and a high-frequency discharge power density of 0.03 W/cm².

The n-type microcrystalline silicon layer was formed to have a thickness of 20 nm, under the following conditions: a reactant gas having a flow rate ratio of SiH₄:H₂:PH₃=1:200:0.02; a reactant gas pressure of 400 Pa; a substrate temperature of 185°C; and a high-frequency discharge power density of 0.2 W/cm².

Next, an intermediate layer for a stacked type photoelectric conversion device is formed by stacking an n-type silicon-based composite layer, an n-type microcrystalline silicon layer, a p-type microcrystalline silicon layer, and a p-type silicon-based composite layer in this order on the n-type microcrystalline silicon layer by a plasma CVD method.

The n-type silicon-based composite layer was formed to have a thickness of 70 nm, under the following conditions: a reactant gas having a flow rate ratio of SiH₄:CO₂:PH₃:H₂=1:0.3:0.01:100; a reactant gas pressure of 1500 Pa; a substrate temperature of 200°C; and a high-frequency discharge power density of 0.2 W/cm². Thus, the n-type silicon-based composite layer including n-type microcrystalline silicon and silicon oxide was formed.

The n-type microcrystalline silicon layer was formed to have a thickness of 30 nm, under the following conditions: a reactant gas having a flow rate ratio of SiH₄:H₂:PH₃=1:200:0.02; a reactant gas pressure of 400 Pa; a substrate temperature of 185°C; and a high-frequency discharge power density of 0.2 W/cm².

The p-type microcrystalline silicon layer was formed to have a thickness of 30 nm, under the following conditions: a reactant gas having a flow rate ratio of SiH₄:H₂:B₂H₆=1:200:0.01; a reactant gas pressure of 300 Pa; a substrate temperature of 200°C; and a high-frequency discharge power density of 0.2 W/cm².

The p-type silicon-based composite layer was formed to have a thickness of 70 nm, under the following conditions: a reactant gas having a flow rate ratio of SiH₄:CO₂:B₂H₆:H₂=1:0.2:0.03:10; a reactant gas pressure of 200 Pa; a substrate temperature of 200°C; and a high-frequency discharge power density of 0.015 W/cm². Thus, the p-type silicon-based composite layer including p-type microcrystalline silicon and silicon oxide was formed.

Next, a second photoelectric conversion unit is formed by stacking a p-type microcrystalline silicon layer, an i-type microcrystalline silicon layer, and an n-type microcrystalline silicon layer in this order on the p-type silicon-based composite layer by a plasma CVD method.

The p-type microcrystalline silicon layer was formed to have a thickness of 15 nm, under the following conditions: a reactant gas having a flow rate ratio of SiH₄:H₂:B₂H₆=1:200:0.01; a reactant gas pressure of 300 Pa; a substrate temperature of 200°C; and a high-frequency discharge power density of 0.2 W/cm².

The i-type crystalline silicon layer was formed to have a thickness of 1700 nm, under the following conditions: a reactant gas having a flow rate ratio of SiH₄:H₂=1:90; a reactant gas pressure of 900 Pa; a substrate temperature of 170°C; and a high-frequency discharge power density of 0.15 W/cm².

The n-type microcrystalline silicon layer was formed to have a thickness of 20 nm, under the following conditions: a reactant gas having a flow rate ratio of SiH₄:H₂:PH₃=1:200:0.02; a reactant gas pressure of 900 Pa; a substrate temperature of 170°C; and a high-frequency discharge power density of 0.15 W/cm².

Then, a zinc oxide film having a thickness of 80 nm was formed on the n-type microcrystalline silicon layer, and subsequently a silver film having a thickness of 300 nm was formed, by a sputtering method, thereby fabricating a stacked type photoelectric conversion device according to Example 1.

As shown in Table 1, the p-type impurity concentration in the p-type amorphous silicon carbide layer of the first photoelectric conversion unit of the stacked type photoelectric conversion device according to Example 1 was 1 × 10²⁰ atoms/cm³, and the n-type impurity concentration in the n-type microcrystalline silicon layer was 1 × 10²¹ atoms/cm³.

Moreover, as shown in Table 1, the n-type impurity concentration in the n-type silicon-based composite layer of the intermediate layer for a stacked type photoelectric conversion device of the stacked type photoelectric conversion device according to Example 1 was 1 × 10²¹ atoms/cm³, the n-type impurity concentration in the n-type microcrystalline silicon layer was 1 × 10²¹ atoms/cm³, the p-type impurity concentration in the p-type microcrystalline silicon layer was 1 × 10²⁰ atoms/cm³, and the p-type impurity concentration in the p-type silicon-based composite layer was 1 × 10²⁰ atoms/cm³. Furthermore, as shown in Table 1, the n-type impurity concentration in the n-type silicon-based stacked body formed of a stacked body of the n-type silicon-based composite layer and the n-type microcrystalline silicon layer of the stacked type photoelectric conversion device according to Example 1 was 1 × 10²¹ atoms/cm³, and the p-type impurity concentration in the p-type silicon-based stacked body formed of a stacked body of the p-type microcrystalline silicon layer and the p-type silicon-based composite layer was 1 × 10²⁰ atoms/cm³.

Furthermore, as shown in Table 1, the p-type impurity concentration in the p-type microcrystalline silicon layer of the second photoelectric conversion unit of the stacked type photoelectric conversion device according to Example 1 was 5 × 10¹⁹ atoms/cm³, and the n-type impurity concentration in the n-type microcrystalline silicon layer was 1 × 10²¹ atoms/cm³_{.}

It is noted that each of the n-type impurity concentration and the p-type impurity concentration in each of the above-described layers was determined by measuring them by SIMS for a stacked type photoelectric conversion device fabricated separately under the same conditions as described above. This is also true in the examples and comparative examples described below.

The stacked type photoelectric conversion device according to Example 1 fabricated as above was subsequently irradiated with AM 1.5 light having an energy density of 1 kW/m² at 25°C, using a solar simulator, and an open-circuit voltage (Voc), a short-circuit current density (Jsc), a fill factor (FF), and a conversion efficiency (Eff) of the stacked type photoelectric conversion device according to Example 1 were determined. The results are shown in Table 2.

As shown in Table 2, the stacked type photoelectric conversion device according to Example 1 had an open-circuit voltage of 1.40 V, a short-circuit current density of 12.3 mA/cm², a fill factor of 0.71, and a conversion efficiency of 12.2%.

### <Example 2>

A stacked type photoelectric conversion device according to Example 2 was fabricated as in Example 1, except that as shown in Table 1, the n-type impurity concentration in the n-type microcrystalline silicon layer of the first photoelectric conversion unit was set to 1 × 10¹⁸ atoms/cm³, and the n-type impurity concentration in each of the n-type silicon-based composite layer, the n-type microcrystalline silicon layer, and the n-type silicon-based stacked body of the intermediate layer for a stacked type photoelectric conversion device was set to 3 × 10¹⁸ atoms/cm³_{.}

Then, an open-circuit voltage (Voc), a short-circuit current density (Jsc), a fill factor (FF), and a conversion efficiency (Eff) of the stacked type photoelectric conversion device according to Example 2 were determined as in Example 1. The results are shown in Table 2.

As shown in Table 2, the stacked type photoelectric conversion device according to Example 2 had an open-circuit voltage of 1.43 V, a short-circuit current density of 12.7 mA/cm², a fill factor of 0.71, and a conversion efficiency of 12.9%.

### <Example 3>

A stacked type photoelectric conversion device according to Example 3 was fabricated as in Example 1, except that as shown in Table 1, the n-type impurity concentration in the n-type microcrystalline silicon layer of the first photoelectric conversion unit was set to 2 × 10²⁰ atoms/cm³, and the n-type impurity concentration in each of the n-type silicon-based composite layer, the n-type microcrystalline silicon layer, and the n-type silicon-based stacked body of the intermediate layer for a stacked type photoelectric conversion device was set to 2 × 10²⁰ atoms/cm³_{.}

Then, an open-circuit voltage (Voc), a short-circuit current density (Jsc), a fill factor (FF), and a conversion efficiency (Eff) of the stacked type photoelectric conversion device according to Example 3 were determined as in Example 1. The results are shown in Table 2.

As shown in Table 2, the stacked type photoelectric conversion device according to Example 3 had an open-circuit voltage of 1.45 V, a short-circuit current density of 12.6 mA/cm², a fill factor of 0.74, and a conversion efficiency of 13.5%.

### <Example 4>

A stacked type photoelectric conversion device according to Example 4 was fabricated as in Example 1, except that as shown in Table 1, the n-type impurity concentration in the n-type microcrystalline silicon layer of the first photoelectric conversion unit was set to 5 × 10²¹ atoms/cm³, and the n-type impurity concentration in each of the n-type silicon-based composite layer, the n-type microcrystalline silicon layer, and the n-type silicon-based stacked body of the intermediate layer for a stacked type photoelectric conversion device was set to 5 × 10²¹ atoms/cm³.

Then, an open-circuit voltage (Voc), a short-circuit current density (Jsc), a fill factor (FF), and a conversion efficiency (Eff) of the stacked type photoelectric conversion device according to Example 4 were determined as in Example 1. The results are shown in Table 2.

As shown in Table 2, the stacked type photoelectric conversion device according to Example 4 had an open-circuit voltage of 1.35 V, a short-circuit current density of 12.3 mA/cm², a fill factor of 0.69, and a conversion efficiency of 11.5%.

### <Example 5>

A stacked type photoelectric conversion device according to Example 5 was fabricated as in Example 1, except that as shown in Table 1, the p-type impurity concentration in each of the p-type microcrystalline silicon layer, the p-type silicon-based composite layer, and the p-type silicon-based stacked body in the intermediate layer for a stacked type photoelectric conversion device was set to 3 × 10¹⁹ atoms/cm³, and the p-type impurity concentration in the p-type microcrystalline silicon layer of the second photoelectric conversion unit was set to 1 × 10¹⁹ atoms/cm³.

Then, an open-circuit voltage (Voc), a short-circuit current density (Jsc), a fill factor (FF), and a conversion efficiency (Eff) of the stacked type photoelectric conversion device according to Example 5 were determined as in Example 1. The results are shown in Table 2.

As shown in Table 2, the stacked type photoelectric conversion device according to Example 5 had an open-circuit voltage of 1.41 V, a short-circuit current density of 13.2 mA/cm², a fill factor of 0.71, and a conversion efficiency of 13.2%.

### <Example 6>

A stacked type photoelectric conversion device according to Example 6 was fabricated as in Example 1, except that as shown in Table 1, the p-type impurity concentration in each of the p-type microcrystalline silicon layer, the p-type silicon-based composite layer, and the p-type silicon-based stacked body in the intermediate layer for a stacked type photoelectric conversion device was set to 7 × 10¹⁹ atoms/cm³, and the p-type impurity concentration in the p-type microcrystalline silicon layer of the second photoelectric conversion unit was set to 1 × 10¹⁹ atoms/cm³.

Then, an open-circuit voltage (Voc), a short-circuit current density (Jsc), a fill factor (FF), and a conversion efficiency (Eff) of the stacked type photoelectric conversion device according to Example 6 were determined as in Example 1. The results are shown in Table 2.

As shown in Table 2, the stacked type photoelectric conversion device according to Example 6 had an open-circuit voltage of 1.43 V, a short-circuit current density of 13.0 mA/cm², a fill factor of 0.73, and a conversion efficiency of 13.6%.

### <Example 7>

A stacked type photoelectric conversion device according to Example 7 was fabricated as in Example 1, except that as shown in Table 1, the p-type impurity concentration in each of the p-type microcrystalline silicon layer, the p-type silicon-based composite layer, and the p-type silicon-based stacked body in the intermediate layer for a stacked type photoelectric conversion device was set to 2 × 10²⁰ atoms/cm³, and the p-type impurity concentration in the p-type microcrystalline silicon layer of the second photoelectric conversion unit was set to 2 × 10²¹ atoms/cm³.

Then, an open-circuit voltage (Voc), a short-circuit current density (Jsc), a fill factor (FF), and a conversion efficiency (Eff) of the stacked type photoelectric conversion device according to Example 7 were determined as in Example 1. The results are shown in Table 2.

As shown in Table 2, the stacked type photoelectric conversion device according to Example 7 had an open-circuit voltage of 1.44 V, a short-circuit current density of 13.0 mA/cm², a fill factor of 0.74, and a conversion efficiency of 13.9%.

### <Example 8>

A stacked type photoelectric conversion device according to Example 8 was fabricated as in Example 1, except that as shown in Table 1, the p-type impurity concentration in each of the p-type microcrystalline silicon layer, the p-type silicon-based composite layer, and the p-type silicon-based stacked body in the intermediate layer for a stacked type photoelectric conversion device was set to 2 × 10²¹ atoms/cm³, and the p-type impurity concentration in the p-type microcrystalline silicon layer of the second photoelectric conversion unit was set to 2 × 10²¹ atoms/cm³.

Then, an open-circuit voltage (Voc), a short-circuit current density (Jsc), a fill factor (FF), and a conversion efficiency (Eff) of the stacked type photoelectric conversion device according to Example 8 were determined as in Example 1. The results are shown in Table 2.

As shown in Table 2, the stacked type photoelectric conversion device according to Example 8 had an open-circuit voltage of 1.40 V, a short-circuit current density of 12.5 mA/cm², a fill factor of 0.71, and a conversion efficiency of 12.5%.

### <Example 9>

A stacked type photoelectric conversion device according to Example 9 was fabricated as in Example 1, except that as shown in Table 1, the n-type impurity concentration in the n-type microcrystalline silicon layer of the first photoelectric conversion unit was set to 1 × 10¹⁸ atoms/cm³, the n-type impurity concentration in each of the n-type silicon-based composite layer, the n-type microcrystalline silicon layer, and the n-type silicon-based stacked body of the intermediate layer for a stacked type photoelectric conversion device was set to 3.95 × 10¹⁸ atoms/cm³, the p-type impurity concentration in each of the p-type microcrystalline silicon layer, the p-type silicon-based composite layer, and the p-type silicon-based stacked body in the intermediate layer for a stacked type photoelectric conversion device was set to 3.76 × 10¹⁹ atoms/cm³, and the p-type impurity concentration in the p-type microcrystalline silicon layer of the second photoelectric conversion unit was set to 1 × 10¹⁹ atoms/cm³.

Then, an open-circuit voltage (Voc), a short-circuit current density (Jsc), a fill factor (FF), and a conversion efficiency (Eff) of the stacked type photoelectric conversion device according to Example 9 were determined as in Example 1. The results are shown in Table 2.

As shown in Table 2, the stacked type photoelectric conversion device according to Example 9 had an open-circuit voltage of 1.41 V, a short-circuit current density of 12.9 mA/cm², a fill factor of 0.71, and a conversion efficiency of 12.8%.

### <Example 10>

A stacked type photoelectric conversion device according to Example 10 was fabricated as in Example 1, except that as shown in Table 1, the n-type impurity concentration in the n-type microcrystalline silicon layer of the first photoelectric conversion unit was set to 1 × 10¹⁹ atoms/cm³, the n-type impurity concentration in each of the n-type silicon-based composite layer, the n-type microcrystalline silicon layer, and the n-type silicon-based stacked body of the intermediate layer for a stacked type photoelectric conversion device was set to 5 × 10¹⁹ atoms/cm³, the p-type impurity concentration in each of the p-type microcrystalline silicon layer, the p-type silicon-based composite layer, and the p-type silicon-based stacked body in the intermediate layer for a stacked type photoelectric conversion device was set to 5 × 10¹⁹ atoms/cm³, and the p-type impurity concentration in the p-type microcrystalline silicon layer of the second photoelectric conversion unit was set to 1 × 10¹⁹ atoms/cm³.

Then, an open-circuit voltage (Voc), a short-circuit current density (Jsc), a fill factor (FF), and a conversion efficiency (Eff) of the stacked type photoelectric conversion device according to Example 10 were determined as in Example 1. The results are shown in Table 2.

As shown in Table 2, the stacked type photoelectric conversion device according to Example 10 had an open-circuit voltage of 1.44 V, a short-circuit current density of 13.3 mA/cm², a fill factor of 0.74, and a conversion efficiency of 14.2%.

### <Example 11>

A stacked type photoelectric conversion device according to Example 11 was fabricated as in Example 1, except that as shown in Table 1, the n-type impurity concentration in the n-type microcrystalline silicon layer of the first photoelectric conversion unit was set to 1 × 10¹⁸ atoms/cm³, the n-type impurity concentration in each of the n-type silicon-based composite layer, the n-type microcrystalline silicon layer, and the n-type silicon-based stacked body of the intermediate layer for a stacked type photoelectric conversion device was set to 3.95 × 10¹⁸ atoms/cm³, the p-type impurity concentration in each of the p-type microcrystalline silicon layer, the p-type silicon-based composite layer, and the p-type silicon-based stacked body in the intermediate layer for a stacked type photoelectric conversion device was set to 2 × 10²¹ atoms/cm³, and the p-type impurity concentration in the p-type microcrystalline silicon layer of the second photoelectric conversion unit was set to 2 × 10²¹ atoms/cm³_{.}

Then, an open-circuit voltage (Voc), a short-circuit current density (Jsc), a fill factor (FF), and a conversion efficiency (Eff) of the stacked type photoelectric conversion device according to Example 11 were determined as in Example 1. The results are shown in Table 2.

As shown in Table 2, the stacked type photoelectric conversion device according to Example 11 had an open-circuit voltage of 1.42 V, a short-circuit current density of 12.8 mA/cm², a fill factor of 0.73, and a conversion efficiency of 13.3%.

### <Example 12>

A stacked type photoelectric conversion device according to Example 12 was fabricated as in Example 1, except that as shown in Table 1, the n-type impurity concentration in the n-type microcrystalline silicon layer of the first photoelectric conversion unit was set to 2 × 10²¹ atoms/cm³, the n-type impurity concentration in each of the n-type silicon-based composite layer, the n-type microcrystalline silicon layer, and the n-type silicon-based stacked body of the intermediate layer for a stacked type photoelectric conversion device was set to 2 × 10²¹ atoms/cm³, the p-type impurity concentration in each of the p-type microcrystalline silicon layer, the p-type silicon-based composite layer, and the p-type silicon-based stacked body in the intermediate layer for a stacked type photoelectric conversion device was set to 3.76 × 10¹⁹ atoms/cm³, and the p-type impurity concentration in the p-type microcrystalline silicon layer of the second photoelectric conversion unit was set to 1 × 10¹⁹ atoms/cm³.

Then, an open-circuit voltage (Voc), a short-circuit current density (Jsc), a fill factor (FF), and a conversion efficiency (Eff) of the stacked type photoelectric conversion device according to Example 12 were determined as in Example 1. The results are shown in Table 2.

As shown in Table 2, the stacked type photoelectric conversion device according to Example 12 had an open-circuit voltage of 1.43 V, a short-circuit current density of 12.8 mA/cm², a fill factor of 0.74, and a conversion efficiency of 13.5%.

### <Comparative Example 1 >

Initially, a first photoelectric conversion unit was formed by stacking an SnO₂ film, a p-type amorphous silicon carbide layer, an i-type amorphous silicon layer, and an n-type microcrystalline silicon layer in this order on a surface of a glass substrate by a plasma CVD method, using the same method and conditions as described in Example 1.

Next, an n-type silicon-based composite layer and an n-type microcrystalline silicon layer were stacked in this order on the n-type microcrystalline silicon layer of the first photoelectric conversion unit by a plasma CVD method, using the same method and conditions as described in Example 1. Then, an n-type silicon-based composite layer was formed to have a thickness of 70 nm on the n-type microcrystalline silicon layer, under the following conditions: a reactant gas having a flow rate ratio of SiH₄:CO₂:PH₃:H₂=1:0.3:0.01:100; a reactant gas pressure of 1500 Pa; a substrate temperature of 200°C; and a high-frequency discharge power density of 0.2 W/cm². As a result, an intermediate layer made of a stacked body of the n-type silicon-based composite layer, the n-type microcrystalline silicon layer, and the n-type silicon-based composite layer was formed.

Next, a second photoelectric conversion unit was formed by stacking a p-type microcrystalline silicon layer, an i-type crystalline silicon layer, and an n-type microcrystalline silicon layer in this order on the n-type silicon-based composite layer of the intermediate layer, by a plasma CVD method, using the same method and conditions as described in Example 1.

A zinc oxide film and a silver film were subsequently formed in this order on the n-type microcrystalline silicon layer of the second photoelectric conversion unit, using the same method and conditions as described in Example 1, thereby fabricating a stacked type photoelectric conversion device according to Comparative Example 1.

Then, an open-circuit voltage (Voc), a short-circuit current density (Jsc), a fill factor (FF), and a conversion efficiency (Eff) of the stacked type photoelectric conversion device according to Comparative Example 1 were determined as in Example 1. The results are shown in Table 2.

As shown in Table 2, the stacked type photoelectric conversion device according to Comparative Example 1 had an open-circuit voltage of 1.25 V, a short-circuit current density of 12.3 mA/cm², a fill factor of 0.72, and a conversion efficiency of 11.1 %.

### <Comparative Example 2>

A stacked type photoelectric conversion device according to Comparative Example 2 was fabricated as in Comparative Example 1, except that the structure of the intermediate layer was changed to have a single n-type silicon-based composite layer only.

Then, an open-circuit voltage (Voc), a short-circuit current density (Jsc), a fill factor (FF), and a conversion efficiency (Eff) of the stacked type photoelectric conversion device according to Comparative Example 2 were determined as in Example 1. The results are shown in Table 2.

As shown in Table 2, the stacked type photoelectric conversion device according to Comparative Example 2 had an open-circuit voltage of 1.25 V, a short-circuit current density of 12.5 mA/cm², a fill factor of 0.70, and a conversion efficiency of 10.9%.

**[Table 1]**

| | First Photoelectric Conversion Unit | Intermediate Layer for Stacked Type Photoelectric Conversion Device | | | | | | Second Photoelectric Conversion Unit |
|---|---|---|---|---|---|---|---|---|
| | | N-Type Silicon Stacked Body | | | P-Type Silicon Stacked Body | | | |
| | N-Type Microcrystalline Si Layer | N-Type Si Composite Layer | N-Type Microcrystalline Si Layer | As a Whole | P-Type Microcrystalline Si Layer | P-Type Si Composite Layer | As a Whole | P-Type Microcrystalline Si Layer |
| Example 1 | 1×10²¹ | 1×10²¹ | 1×10²¹ | 1×10²¹ | 1×10²⁰ | 1×10²⁰ | 1×10²⁰ | 5×10¹⁹ |
| Example 2 | 1×10¹⁸ | 3×10¹⁸ | 3×10¹⁸ | 3×10¹⁸ | 1×10²⁰ | 1×10²⁰ | 1×10²⁰ | 5×10¹⁹ |
| Example 3 | 2×10²⁰ | 2×10²⁰ | 2×10²⁰ | 2×10²⁰ | 1×10²⁰ | 1×10²⁰ | 1×10²⁰ | 5×10¹⁹ |
| Example 4 | 5×10²¹ | 5×10²¹ | 5×10²¹ | 5×10²¹ | 1×10²⁰ | 1×10²⁰ | 1×10²⁰ | 5×10¹⁹ |
| Example 5 | 1×10²¹ | 1×10²¹ | 1×10²¹ | 1×10²¹ | 3×10¹⁹ | 3×10¹⁹ | 3×10¹⁹ | 1×10¹⁹ |
| Example 6 | 1×10²¹ | 1×10²¹ | 1×10²¹ | 1×10²¹ | 7×10¹⁹ | 7×10¹⁹ | 7×10¹⁹ | 1×10¹⁹ |
| Example 7 | 1×10²¹ | 1×10²¹ | 1×10²¹ | 1×10²¹ | 2×10²⁰ | 2×10²⁰ | 2×10²⁰ | 2×10²¹ |
| Example 8 | 1×10²¹ | 1×10²¹ | 1×10²¹ | 1×10²¹ | 2×10²¹ | 2×10²¹ | 2×10²¹ | 2×10²¹ |
| Example 9 | 1×10¹⁸ | 3.95×10¹⁸ | 3.95×10¹⁸ | 3.95×10¹⁸ | 3.76×10¹⁹ | 3.76×10¹⁹ | 3.76×10¹⁹ | 1×10¹⁹ |
| Example 10 | 1×10¹⁹ | 5×10¹⁹ | 5×10¹⁹ | 5×10¹⁹ | 5×10¹⁹ | 5×10¹⁹ | 5×10¹⁹ | 1×10¹⁹ |
| Example 11 | 1×10¹⁸ | 3.95×10¹⁸ | 3.95×10¹⁸ | 3.95×10¹⁸ | 2×10²¹ | 2×10²¹ | 2×10²¹ | 2×10²¹ |
| Example 12 | 2×10²¹ | 2×10²¹ | 2×10²¹ | 2×10²¹ | 3.76×10¹⁹ | 3.76×10¹⁹ | 3.76×10¹⁹ | 1×10¹⁹ |

**[Table 2]**

| | Evaluation | | | |
|---|---|---|---|---|
| | Open-Circuit Voltage (V) | Short-Circuit Current Density (mA/cm²) | FF | Conversion Efficiency (%) |
| Example 1 | 1.40 | 12.3 | 0.71 | 12.2 |
| Example 2 | 1.43 | 12.7 | 0.71 | 12.9 |
| Example 3 | 1.45 | 12.6 | 0.74 | 13.5 |
| Example 4 | 1.35 | 12.3 | 0.69 | 11.5 |
| Example 5 | 1.41 | 13.2 | 0.71 | 13.2 |
| Example 6 | 1.43 | 13.0 | 0.73 | 13.6 |
| Example 7 | 1.44 | 13.0 | 0.74 | 13.9 |
| Example 8 | 1.40 | 12.5 | 0.71 | 12.5 |
| Example 9 | 1.41 | 12.9 | 0.71 | 12.8 |
| Example 10 | 1.44 | 13.3 | 0.74 | 14.2 |
| Example 11 | 1.42 | 12.8 | 0.73 | 13.3 |
| Example 12 | 1.43 | 12.8 | 0.74 | 13.5 |
| Comparative Example 1 | 1.25 | 12.3 | 0.72 | 11.1 |
| Comparative Example 2 | 1.25 | 12.5 | 0.70 | 10.9 |

As shown in Table 2, the stacked type photoelectric conversion devices according to Examples 1 to 12 were confirmed to be superior in characteristics to the stacked type photoelectric conversion devices according to Comparative Examples 1 and 2. This is because the intermediate layer for a stacked type photoelectric conversion device according to each of Examples 1 to 12, composed of the stacked body of the n-type silicon-based composite layer/the n-type microcrystalline silicon layer/the p-type microcrystalline silicon layer/the p-type silicon-based composite layer, is more effective at improving the characteristics of the stacked type photoelectric conversion device than the intermediate layer according to Comparative Example 1 composed of the stacked body of the n-type silicon-based composite layer/the n-type microcrystalline silicon layer/the n-type silicon-based composite layer, and the intermediate layer according to Comparative Example 2 composed of the n-type silicon-based composite layer only.

It should be understood that the embodiments and examples disclosed herein are illustrative and non-restrictive in every respect. The scope of the present invention is defined by the terms of the claims, rather than by the foregoing description, and is intended to include any modifications within the scope and meaning equivalent to the terms of the claims.

### INDUSTRIAL APPLICABILITY

The present invention can be utilized as an intermediate layer for a stacked type photoelectric conversion device used in a stacked type photoelectric conversion device for a variety of purposes such as a solar cell, a photosensor, and a display, a stacked type photoelectric conversion device using the intermediate layer for a stacked type photoelectric conversion device, and a method for manufacturing a stacked type photoelectric conversion device.

### REFERENCE SIGNS LIST

1: transparent substrate; 2: transparent electrode layer; 3: first photoelectric conversion unit; 4: intermediate layer for a stacked type photoelectric conversion device; 5: second photoelectric conversion unit; 6: back electrode layer; 31: first p-type silicon-based semiconductor layer; 32: first i-type silicon-based semiconductor layer; 33: first n-type silicon-based semiconductor layer; 41: n-type silicon-based stacked body; 41a: n-type crystalline silicon-based semiconductor layer; 41b: n-type silicon-based composite layer; 42: p-type silicon-based stacked body; 42a: p-type crystalline silicon-based semiconductor layer; 42b: p-type silicon-based composite layer; 51: second p-type silicon-based semiconductor layer; 52: second i-type silicon-based semiconductor layer; 53: second n-type silicon-based semiconductor layer; 101: glass substrate; 102: SnO₂ film; 103: amorphous photoelectric conversion unit; 104: intermediate layer; 105: crystalline silicon photoelectric conversion unit; 106: stacked body; 201: glass substrate; 202: SnO₂ film; 203: front photoelectric conversion unit; 204: n-type silicon composite layer; 205: rear photoelectric conversion unit; 206: stacked body; 1031: p-type SiC layer; 1032: i-type amorphous Si layer; 1033: n-type µc-Si layer; 1041: conductive SiOₓ layer; 1042: n-type µc-Si layer; 1043: conductive SiOₓ layer; 1051: p-type µC-Si layer; 1052: i-type crystalline Si layer; 1053: n-type µc-Si layer; 2031: p-type amorphous SiC layer; 2032: i-type amorphous Si layer; 2033: n-type µc-Si layer; 2051: p-type µc-Si layer; 2052: i-type crystalline Si layer; 2053: n-type µc-Si layer.

## Claims

1. An intermediate layer (4) for a stacked type photoelectric conversion device comprising:
an n-type silicon-based stacked body (41) including an n-type crystalline silicon-based semiconductor layer (41a) and an n-type silicon-based composite layer (41b); and
a p-type silicon-based stacked body (42) including a p-type crystalline silicon-based semiconductor layer (42a) and a p-type silicon-based composite layer (42b),
said n-type crystalline silicon-based semiconductor layer (41a) of said n-type silicon-based stacked body (41) being in contact with said p-type crystalline silicon-based semiconductor layer (42a) of said p-type silicon-based stacked body (42).

2. The intermediate layer (4) for a stacked type photoelectric conversion device according to claim 1, wherein
said n-type crystalline silicon-based semiconductor layer (41a) and said n-type silicon-based composite layer (41b) are alternately stacked on each other in said n-type silicon-based stacked body (41), and
said p-type crystalline silicon-based semiconductor layer (42a) and said p-type silicon-based composite layer (42b) are stacked on each other in said p-type silicon-based stacked body (42).

3. The intermediate layer (4) for a stacked type photoelectric conversion device according to claim 1 or 2, wherein
said n-type silicon-based composite layer (41b) includes an n-type crystalline silicon-based semiconductor and an insulating silicon-based compound.

4. The intermediate layer (4) for a stacked type photoelectric conversion device according to any of claims 1 to 3, wherein
said n-type silicon-based stacked body (41) has an n-type impurity concentration of not lower than 3.95 × 10¹⁸ atoms/cm³ and not higher than 2 × 10²² atoms/cm³.

5. The intermediate layer (4) for a stacked type photoelectric conversion device according to any of claims 1 to 4, wherein
said p-type silicon-based composite layer (42b) includes a p-type crystalline silicon-based semiconductor and an insulating silicon-based compound.

6. The intermediate layer (4) for a stacked type photoelectric conversion device according to any of claims 1 to 5, wherein
said p-type silicon-based stacked body (42) has a p-type impurity concentration of not lower than 3.76 × 10¹⁹ atoms/cm³ and not higher than 2 × 10²¹ atoms/cm³.

7. A stacked type photoelectric conversion device comprising:
an intermediate layer (4) for a stacked type photoelectric conversion device according to any of claims 1 to 6;
a first photoelectric conversion unit (3) provided on one surface of said intermediate layer (4) for a stacked type photoelectric conversion device; and
a second photoelectric conversion unit (5) provided on the other surface of said intermediate layer (4) for a stacked type photoelectric conversion device,
said first photoelectric conversion unit (3) including an n-type silicon-based semiconductor layer (33) facing said intermediate layer (4) for a stacked type photoelectric conversion device,
said second photoelectric conversion unit (5) including a p-type silicon-based semiconductor layer (51) facing said intermediate layer (4) for a stacked type photoelectric conversion device,
said n-type silicon-based composite layer (41b) of said intermediate layer (4) for a stacked type photoelectric conversion device being in contact with said n-type silicon-based semiconductor layer (33) of said first photoelectric conversion unit (3), and
said p-type silicon-based composite layer (42b) of said intermediate layer (4) for a stacked type photoelectric conversion device being in contact with said p-type silicon-based semiconductor layer (51) of said second photoelectric conversion unit (5).

8. The stacked type photoelectric conversion device according to claim 7, wherein
said n-type silicon-based semiconductor layer (33) of said first photoelectric conversion unit (3) has an n-type impurity concentration of not lower than 1 × 10¹⁹ atoms/cm³ and not higher than 2 × 10²¹ atoms/cm³.

9. The stacked type photoelectric conversion device according to claim 7 or 8, wherein
said p-type silicon-based semiconductor layer (51) of said second photoelectric conversion unit (5) has a p-type impurity concentration of not lower than 1 × 10¹⁸ atoms/cm³ and not higher than 2 × 10²² atoms/cm³.

10. A method for manufacturing a stacked type photoelectric conversion device comprising the steps of:
forming a first photoelectric conversion unit (3) by stacking a p-type silicon-based semiconductor layer (31), an i-type silicon-based semiconductor layer (32), and an n-type silicon-based semiconductor layer (33) in this order on a transparent substrate (1);
forming an intermediate layer (4) for a stacked type photoelectric conversion device according to any of claims 1 to 6 on said first photoelectric conversion unit (3); and
forming second photoelectric conversion unit (5) by stacking a p-type silicon-based semiconductor layer (51), an i-type silicon-based semiconductor layer (52), and an n-type silicon-based semiconductor layer (53) in this order on said intermediate layer (4) for a stacked type photoelectric conversion device,
the step of forming said intermediate layer (4) for a stacked type photoelectric conversion device including the step of stacking said n-type silicon-based composite layer (41b) of said intermediate layer (4) for a stacked type photoelectric conversion device to be in contact with said n-type silicon-based semiconductor layer (33) of said first photoelectric conversion unit (3), and
the step of forming said second photoelectric conversion unit (5) including the step of stacking said p-type silicon-based semiconductor layer (51) of said second photoelectric conversion unit (5) to be in contact with said p-type silicon-based composite layer (42b) of said intermediate layer for a stacked type photoelectric conversion device.
